# EUROPEAN PATENT SPECIFICATION

(11) **EP 0 471 003 B1**
(45) Date of publication and mention of the grant of the patent: **17.11.1994**
(21) Application number: 90907603.6
(22) Date of filing: 09.04.1990
(51) Int. Cl.: H05K 3/30, H05K 7/06

(54) **METHOD OF GROUNDING AN ULTRA HIGH DENSITY PAD ARRAY CHIP CARRIER**
VERFAHREN ZUR ERDUNG EINES CHIP-TRÄGERS MIT KONTAKTFELDERN VON ULTRAHOHER DICHTE
PROCEDE DE MISE A LA TERRE D'UN SUPPORT DE PUCES A RESEAU DE PLOTS D ULTRA HAUTE DENSITE

(30) Priority: 01.05.1989 US 345280
(43) Date of publication of application: 19.02.1992
(73) Proprietor: MOTOROLA, INC., Schaumburg, IL 60196 (US)
(72) Inventor: FREYMAN, Bruce, J., Sunrise, FL 33313 (US); MILES, Barry, M., Plantation, FL 33324 (US); JUSKEY, Frank, J., Coral Springs, FL 33065 (US)
(74) Representative: Lupton, Frederick
(86) International application number: PCT/US90/01828
(87) International publication number: WO 90/13991

(56) References cited:
- EP-A- 0 057 085
- EP-A- 0 238 282
- WO-A-87/04316
- US-A- 4 574 879
- US-A- 4 631 639
- IBM TECHNICAL DISCLOSURE BULLETIN, vol. 27, no. 4A, September 1984, NEW YORK, US, pages 1955 - 1956; K. HERMANN: 'Integrated Circuit Chips Directly Mounted on Organic Printed Circuit Cards'

## Description

### Technical Field

This invention relates generally to a method of making an ultra high density pad array chip carrier, more particularly a method for grounding of an integrated circuit (I.C.) device in ultra high density pad array chip carriers.

### Background Art

Grounding ultra high density chip carrier assemblies typically requires a wire bond from a conductive runner acting as ground on a substrate to a metallized polyimide film die pad. Wire bonding in chip carrier assemblies is disadvantageous due to the larger die pad size required to bond the wire, larger production and material costs, and lower current carrying capacities of typical bond wires such as a gold bond wire.

Eliminating wire bonding to metallized polyimide film die pads reduces several undesirable effects. First, wire bonding requires a larger die pad to allow a wire bonder to place a wire next to the die on the metallized polyimide film die pad. Further, polyimide film (as opposed to metallized alumina) produces poor wire bonds due to its compliant nature. Additionally, eliminating wire bonds permits the elimination of the metal layer on the polyimide die pad, since no wire bonding to the die pad is necessary. Wire bonding requires the operator to change the wire bonder parameters, such as, from a ceramic chip carrier profile to a polyimide film profile in order to make a reliable bond. Grounding a high power integrated circuit device with a wire bond from a polyimide film die pad to a conductor runner is an ineffective method of semiconductor grounding due to the insufficient current carrying capacity of typical bonding wires.

WO-A-87043 16 describes a method of manufacturing a hybrid integrated circuit device in which a semiconductor chip is mounted on a ceramic substrate via a polyimide film.

### Summary of the Invention

In accordance with the invention there is provided a chip carrier assembly comprising: a semiconductor chip having a bottom surface; a substrate including at least one conductive area; a non-conductive polyimide die pad intimately bonded to at least one of the conductive areas of the substrate having at least one passage therethrough, and being positioned between the semiconductor chip and the substrate; wherein an electrically conductive material, located in said at least one passage and between the substrate and the semiconductor chip, provides electrical grounding interconnection between the bottom surface of the semiconductor chip and said one conductive area of the substrate.

In a further aspect of the invention there is provided a method for grounding a semiconductor chip through a chip carrier assembly comprising a substrate having metallized runners connected to a ground pad, the method comprising the steps of: (a) applying an adhesive to a polyimide film die pad at a temperature that causes the adhesive to adhere to the die pad without curing; (b) punching a hole through both the die pad and uncured adhesive in a position wherein said hole will be located over a ground pad ; (c) tacking said die pad onto said substrate, positioning said punched hole in said die pad directly over said ground pad, forming a die pad bonded assembly; (d) heat laminating said die pad bonded assembly to fully cure the adhesive; (e) dispensing silver filled epoxy onto the middle of said die pad, forcing the silver filled epoxy through said punched hole so as to form an electrical connection between a semiconductor chip, that is to be placed into the epoxy, and said ground pad; and (f) placing said semiconductor chip into the epoxy.

Disposing of the grounded wire bond by means of the present invention reduces production costs and production time, while increasing the efficiency and effectiveness of the chip carrier assembly.

An exemplary embodiment of the invention will now be described with reference to the accompanying drawings.

### Brief Description of the Drawings

Figure 1 illustrates a top plan view of a chip carrier with a typical pattern of conductive areas.

Figure 2 illustrates a cross section of a chip carrier, die pad, and semiconductor die in accordance with a preferred embodiment of the present invention.

Figure 3 illustrates a top plan view of the chip carrier base with the die pad placed on top of the chip carrier base in accordance with the present invention.

### Detailed Description of the Preferred Embodiment

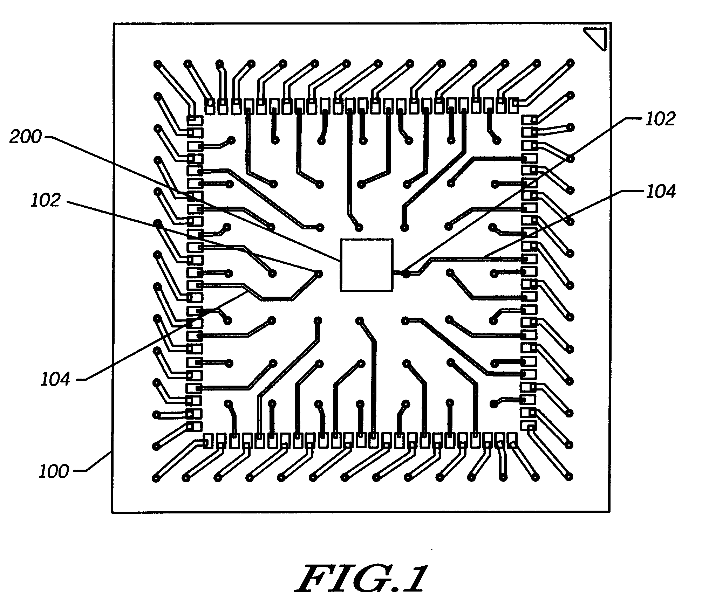

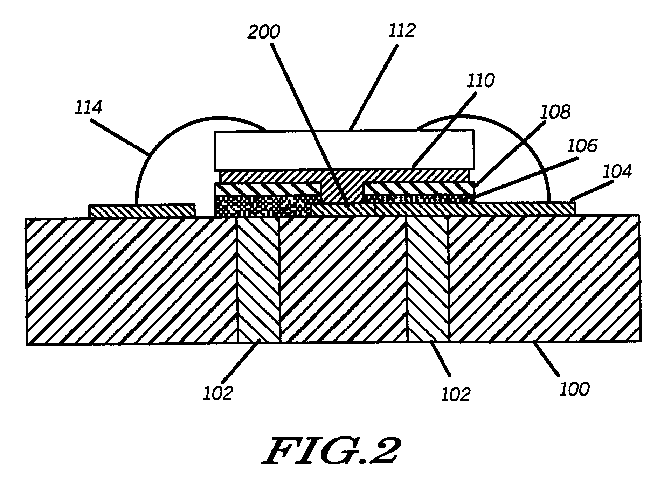

Referring to Figure 1, there is shown an alumina ceramic substrate 100 having conductive areas (or metal runners) (104) deposited thereon. Some of these conductive areas terminate at a metal land (200) that serves as a common grounding point. Preferably, the metal land comprises a square having a size dependent on the design of the substrate, although other shapes may be used. A convenient size of .020 inches X .020 inches (.051cm X .051 cm) facilitates assembly. The metal land 200 is positioned directly below the through-hole in the die pad (108) shown in Figure 2.

Referring to Figure 2, the die pad (108) is affixed to at least a portion of the conductive areas (104) by means of an effective amount of adhesive, preferably Pyralux acrylic adhesive (106) made by Dupont. The die pad (108), either metallized or unmetallized, comprises of a polyimide film .002 inches (.005cm) thick, and laminated with .001 inch (.003cm) Dupont Pyralux modified acrylic adhesive (106). Before the die pad is tacked onto the substrate, a hole, (preferably .020 inches (.051cm) to .100 inches (.255cm) in diameter) is formed in the polyimide film die pad and the attached Pyralux acrylic adhesive. This hole is positioned in the die pad (108) so as to mount over the grounded metal land (200) on the ceramic substrate (100). Optimally, the solder filled throughholes (102) may be electronically connected to the conductive areas of the substrate (104) as is known in the art.

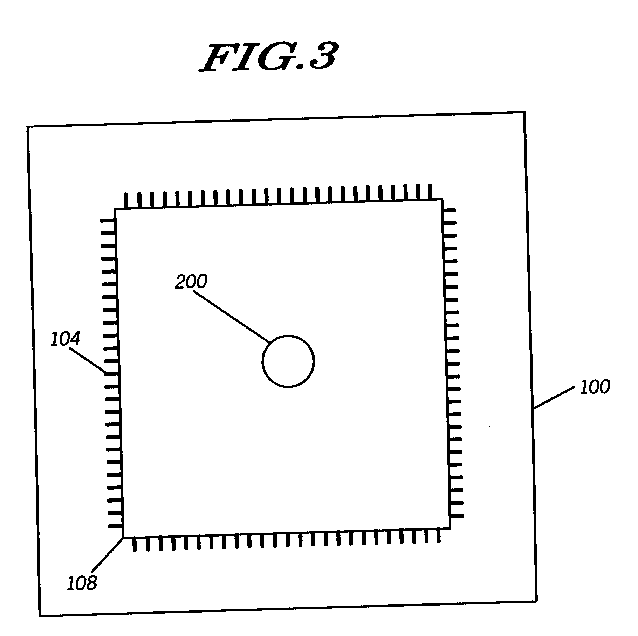

Referring to figures 2 and 3, the die pad and acrylic adhesive is then positioned on the substrate, which is then laminated. The lamination process causes an intimate bond between the die pad (108), the acrylic adhesive (106) and the conductive areas (104).

A conductive material (110) comprising silver filled epoxy flows through the through-hole formed in the die pad (108) and acrylic adhesive (106) to make contact with the grounded metal land (200) on the substrate (100). The silver filled epoxy is also dispensed onto the middle of the die pad, creating an electronic connection between the bottom surface of the semiconductor chip (112) and the grounded metal land (200) when the semiconductor chip (112) is placed into the epoxy in an assembly process.

Finally, wire bonds (114) may be connected from various conductive areas (104) on the substrate to the semiconductor die 112.

## Claims

1. A chip carrier assembly comprising:
a semiconductor chip (112) having a bottom surface;
a substrate (100) including at least one conductive area (200); and
a non-conductive polyimide die pad (108) intimately bonded (106) to at least one of the conductive areas of the substrate having at least one passage therethrough, and being positioned between the semiconductor chip and the substrate; wherein
an electrically conductive material (110), located in said at least one passage and between the substrate (100) and the semiconductor chip (112), provides electrical grounding interconnection between the bottom surface of the semiconductor chip and said one conductive area of the substrate.

2. A chip carrier assembly as defined in claim 1, wherein said substrate comprises an ceramic chip carrier base.

3. The chip carrier assembly as defined in claim 1 or 2 wherein said electrically conductive material comprises conductive metal filled epoxy.

4. The chip carrier assembly of claim 3, wherein said conductive metal filled epoxy comprises silver.

5. A chip carrier assembly as claimed in any preceding claim, wherein said substrate is an alumina ceramic substrate.

6. A chip carrier assembly as claimed in any preceding claim, wherein said substrate is a chip carrier base including metallic runners which constitute the conductive areas.

7. The chip carrier assembly of claim 6, wherein said chip carrier base comprises ceramic alumina.

8. The chip carrier assembly of claim 6, wherein said at least one passsage comprises a punched hole therethrough said die pad positioned directly above said metallic runner.

9. A method for grounding a semiconductor chip (112) through a chip carrier assembly comprising a substrate (100) having metallized runners (104) connected to a ground pad (200), the method comprising the steps of:
(a) applying an adhesive (106) to a polyimide film die pad (108) at a temperature that causes the adhesive to adhere to the die pad without curing;
(b) punching a hole through both the die pad and uncured adhesive in a position wherein said hole will be located over a ground pad (200);
(c) tacking said die pad onto said substrate, positioning said punched hole in said die pad directly over said ground pad, forming a die pad bonded assembly;
(d) heat laminating said die pad bonded assembly to fully cure the adhesive;
(e) dispensing silver filled epoxy (110) onto the middle of said die pad, forcing the silver filled epoxy through said punched hole so as to form an electrical connection between a semiconductor chip, that is to be placed into the epoxy, and said ground pad (200); and
(f) placing said semiconductor chip on the epoxy.

## Patentansprüche

1. Ein Chip-Träger-Zusammenbau, umfassend:
einen Halbleiter-Chip (112), der eine untere Oberfläche hat;
ein Substrat (100), das wenigstens einen leitenden Bereich (200) einschließt; und
einen nichtleitendes Halbleiterbauteil-Kontaktfeld (108) aus Polymid, das eng (106) mit wenigstens einem der leitenden Bereiche des Substrats verbunden ist, der wenigstens einen Durchlaß durch ihn hindurch hat und zwischen dem Halbleiter-Chip und dem Substrat angeordnet ist; in dem
ein elektrisch leitendes Material (110), das sich an dem genannten wenigstens einen Durchlaß und zwischen dem Substrat (100) und dem Halbleiter-Chip (112) befindet eine elektrische Erdungsverbindung zwischen der unteren Oberfläche des Halbleiter-Chip und dem genannten einen leitenden Bereich des Substrats liefert.

2. Ein Chip-Träger-Zusammenbau, wie in Anspruch 1 angegeben, in dem das genannte Substrat eine keramische Chip-Trägerbasis umfaßt.

3. Der Chip-Träger-Zusammenbau, wie in Anspruch 1 oder 2 angegeben, in dem das genannte elektrischleitende Material mit leitendem Metall gefülltes Epoxi umfaßt.

4. Der Chip-Träger-Zusammenbau, des Anspruchs 3, in dem das genannte mit leitendem Metall gefüllte Epoxi Silber umfaßt.

5. Ein Chip-Träger-Zusammenbau, wie in irgendeinem vorhergehenden Anspruch beansprucht, in dem das genannte Substrat ein keramisches Substrat aus Tonerde ist.

6. Ein Chip-Träger-Zusammenbau, wie in irgendeinem vorhergehenden Anspruch beansprucht, in dem das genannte Substrat eine Chip-Träger-Basis ist, die Metalleiter einschließt, die die leitenden Bereiche bilden.

7. Der Chip-Träger-Zusammenbau des Anspruches 6, in dem die genannte Chip-Träger-Basis keramische Tonerde umfaßt.

8. Der Chip-Träger-Zusammenbau des Anspruches 6, in dem der genannte wenigstens eine Durchlaß ein durchgestanztes Loch umfaßt, wobei das genannte Halbleiterbauteil-Kontaktfeld direkt oberhalb des genannten Metalleiters angeordnet ist.

9. Ein Verfahren zur Erdung eines Halbleiter-Chip (112) durch einen Chip-Träger-Zusammenbau, der ein Substrat (100) umfaßt, das Metalleiter (104) hat, die mit einem Erdungsfeld (200) verbunden sind, wobei das Verfahren die Schritte umfaßt:
(a) Aufbringen eines Klebemittels (106) auf einen Halbleiterbauteil-Kontaktfeld aus einem Polymid-Film (108) bei einer Temperatur, die bewirkt, daß das Klebemittel an dem Halbleiterbauteil-Kontaktfeld ohne Aushärten anhaftet;
(b) Stanzen eines Loches durch das Halbleiterbauteil-Kontaktfeld und das ungehärtete Klebemittel in einer Position, in der sich das genannte Loch über einem Erdungsfeld (200) befindet;
(c) Kleben des genannten Halbleiterbauteil-Kontaktfeldes auf dem genannten Substrat, Positionieren des genannten gestanzten Loches in dem genannten Halbleiterbauteil-Kontaktfeld direkt über dem genannten Erdungsfeld, Bilden eines verbundenen Halbleiterbauteil-Kontaktfeld-Zusammenbaus;
(d) Wärmelaminieren des genannten verbudnenen Halbleiterbauteil-Kontaktfeld-Zusammenbaus, um das Klebemittel voll auszuhärten;
(e) Aufbringen von mit Silber gefülltem Epoxi (110) auf die Mitte des genannten Halbleiterbauteil-Kontaktfeldes, Forcieren des mit Silber gefüllten Epoxis durch das genannte gestanzte Loch, um eine elektrische Verbindung zwischen einem Halbleiterchip, der in dem Epoxi angeordnet werden soll, und dem genannten Erdungsfeld (200) zu bilden; und
(f) Anordnen des genannten Halbleiter-Chip in dem Epoxi.

## Revendications

1. Ensemble de support de puces comprenant:
une puce à semi-conducteurs (112) ayant une surface inférieure ;
un substrat (100) comprenant au moins une zone conductrice (200), et
un plot moulé en polyimide non conducteur (108) intimement lié (106) à au moins l'une des zones conductrices du substrat ayant au moins un passage traversant, et étant positionné entre la puce à semiconducteurs et le substrat ; dans lequel
un matériau électriquement conducteur (110), placé dans au moins ledit passage et entre le substrat (100) et la puce à semi-conducteurs (112), fournit une interconnexion de mise à la terre électrique entre la surface inférieure de la puce à semi-conducteurs et ladite zone conductrice du substrat.

2. Ensemble de support de puces selon la revendication 1, dans lequel ledit substrat comprend une base de support de puces en céramique.

3. Ensemble de support de puces selon la revendication 1 ou 2, dans lequel ledit matériau électriquement conducteur comprend une résine époxy chargée de métal conducteur.

4. Ensemble de support de puces selon la revendication 3, dans lequel ladite couche époxy chargée de métal conducteur comprend de l'argent.

5. Ensemble de support de puces selon l'une quelconque des revendications précédentes, dans lequel ledit substrat est un substrat céramique d'alumine.

6. Ensemble de support de puces selon l'une quelconque des revendications précédentes, dans lequel ledit substrat est une base de support de puces comprenant des dépôts métalliques qui constituent les zones conductrices.

7. Ensemble de support de puces selon la revendication 6, dans lequel ladite base de support de puces comprend de l'alumine céramique.

8. Ensemble de support de puces selon la revendication 6, dans lequel au moins un passage comprend un trou poinçonné à travers ledit plot moulé positionné directement au-dessus dudit dépôt métallique.

9. Procédé de mise à la terre d'une puce à semiconducteurs (112) par l'intermédiaire d'un ensemble de support de puces comprenant un substrat (100) ayant des dépôts métallisés (104) reliés à un plot de mise à la terre (200), ledit procédé comportant les étapes suivantes:
(a) application d'un adhésif (106) sur un plot moulé en film de polyimide (108) à une température qui fait adhérer l'adhésif sur le plot moulé sans cuisson ;
(b) poinçonnage d'un trou dans ledit plot moulé et l'adhésif non cuit dans une position où ledit trou sera placé au-dessus d'un plot de mise à la terre (200) ;
(c) adhésion dudit plot moulé sur ledit substrat, pour positionner ledit trou poinçonné dans ledit plot moulé directement au-dessus dudit plot de mise à la terre, formant ainsi un ensemble collé de plot moulé ;
(d) laminage à chaud dudit ensemble collé de plot moulé pour cuire totalement I'adhésif ;
(e) distribution de résine époxy chargée à l'argent (110) au centre dudit plot moulé, forçant ainsi la résine époxy chargée à l'argent à travers ledit trou poinçonné, de manière à former une connexion électrique entre une puce à semi-conducteurs, placée dans la couche époxy, et ledit plot de mise à la terre (200) ; et
(f) placement de ladite puce à semi-conducteurs sur la couche époxy.
